# FASCICULE DE BREVET EUROPEEN

(11) **EP 3 011 070 B1**
(45) Date de publication et mention de la délivrance du brevet: **03.05.2017**
(21) Numéro de dépôt: 14781573.2
(22) Date de dépôt: 09.10.2014
(51) Int. Cl.: C23C 14/02, C23C 14/08, C23C 28/00, C23C 14/00

(54) **PROCÉDÉ DE FABRICATION D'UN ARTICLE REVÊTU, ARTICLE REVÊTU OBTENU PAR UN TEL PROCÉDÉ ET DISPOSITIF ÉLECTRIQUE COMPRENANT UN TEL ARTICLE REVÊTU**
VERFAHREN ZUR HERSTELLUNG EINES BESCHICHTETEN GEGENSTANDS, DURCH DIESES VERFAHREN GEWONNENER BESCHICHTETER GEGENSTAND UND ELEKTRISCHE VORRICHTUNG MIT SOLCH EINEM BESCHICHTETEN GEGENSTAND
METHOD FOR PRODUCING A COATED ITEM, COATED ITEM OBTAINED BY SUCH A METHOD AND ELECTRIC DEVICE COMPRISING SUCH A COATED ITEM

(30) Priorité: 11.10.2013 FR 1359906
(43) Date de publication de la demande: 27.04.2016
(73) Titulaire: Schneider Electric Industries SAS, 92500 Rueil-Malmaison (FR)
(72) Inventeur: CARBONE, Laurent, F-38100 Grenoble (FR); CAILLAULT, Nathalie, F-38210 Vourey (FR)
(74) Mandataire: Brevalex
(86) Numéro de dépôt international: PCT/EP2014/071614
(87) Numéro de publication internationale: WO 2015/052270

(56) Documents cités:
- US-A- 4 052 520
- US-A- 4 161 560
- US-A- 4 533 605
- US-A1- 2012 058 361

## Description

### DOMAINE TECHNIQUE

La présente invention se rapporte au domaine des articles revêtus, c'est-à-dire aux articles comprenant un support et un revêtement disposé sur ce support.

Un tel revêtement est en général destiné à conférer à l'article ainsi revêtu différentes caractéristiques ou propriétés que ne présente pas le support en lui-même. Le revêtement peut ainsi être décoratif ou encore assurer une fonction de protection, notamment contre l'usure, la rayure..., de telles caractéristiques pouvant par ailleurs être cumulatives.

A titre d'exemple d'article revêtu, on peut citer les plaques et/ou boutons de commande de divers dispositifs électriques, notamment des interrupteurs et prises électriques.

La présente invention se rapporte également à un dispositif électrique comprenant un tel article revêtu ainsi qu'à un procédé de fabrication d'un tel article revêtu.

### ÉTAT DE LA TECHNIQUE ANTÉRIEURE

A l'heure actuelle, la tendance consiste à proposer une large gamme d'articles revêtus afin de répondre aux demandes les plus diverses et variées du consommateur.

En particulier, dans le domaine des plaques et/ou boutons de commande d'interrupteurs et autres prises électriques, on cherche à proposer des articles revêtus qui soient le plus en adéquation possible avec la décoration de l'intérieur du consommateur. Pour répondre à cette demande, il devient donc nécessaire de proposer une gamme de couleurs de plaques et/ou boutons de commande qui soit la plus étendue possible.

A ce jour, les articles revêtus, et notamment ces plaques et/ou boutons de commande d'interrupteurs et prises électriques, comprennent un support, classiquement réalisé en matière plastique, et un revêtement disposé sur au moins une face de ce support, cette face étant opposée à celle qui est destinée à être fixée sur une structure telle qu'une structure murale.

Ce revêtement a plusieurs fonctions parmi lesquelles une fonction décorative, notamment par la couleur qu'il confère à la plaque et/ou au bouton de commande, une fonction d'isolation électrique ainsi qu'une fonction de protection puisque ce revêtement permet également de résister aux agressions chimiques et mécaniques, notamment aux rayures.

Ce revêtement, dont l'épaisseur totale est généralement d'au moins 50 µm, comprend plusieurs couches de peinture, de compositions différentes.

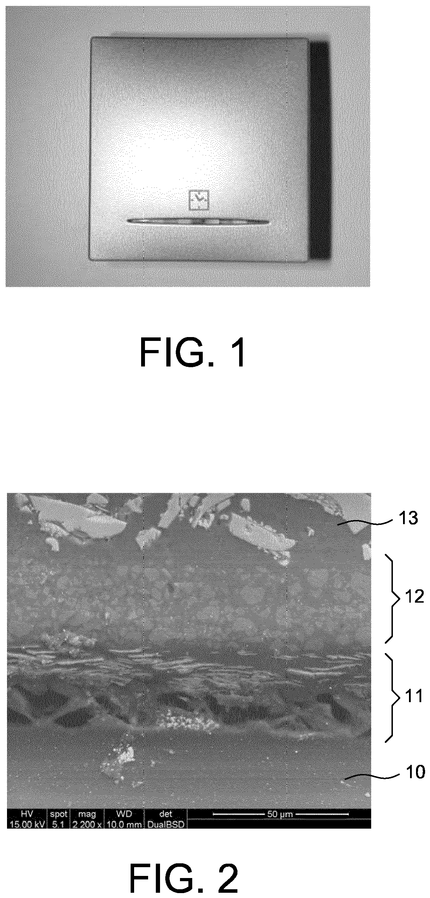

En particulier, dans le cas d'un article revêtu dont le revêtement présente un aspect métallique comme illustré par le cliché de la figure 1, le nombre de couches nécessaire pour la formation dudit revêtement est typiquement de trois. Ainsi, comme le montre le cliché de la figure 2, sur le support 10 classiquement en plastique, sont successivement disposées une première couche 11 comprenant du dioxyde de silicium SiO₂ et présentant une épaisseur d'environ 10 µm, puis une deuxième couche 12 comprenant des particules d'aluminium et présentant une épaisseur d'environ 10 µm et enfin une troisième couche 13 d'un mélange d'aluminium et de dioxyde de silicium SiO₂ et présentant une épaisseur d'environ 40 µm.

Outre le fait que le procédé de fabrication de tels articles revêtus est relativement long et complexe puisqu'il nécessite des dépôts successifs de couches de compositions distinctes les unes des autres, il est également polluant. Aussi, pour éviter tout risque nuisible à l'environnement qu'il pourrait générer, ce procédé de fabrication nécessite la mise en oeuvre non seulement d'équipements lourds, tels que l'installation de rideaux d'eau ou de systèmes d'aspiration destinés à capter les vapeurs nocives de peinture formées lors de l'application des différentes couches, mais également d'étapes industrielles complémentaires, et notamment de retraitement des effluents, tels que ceux provenant des bains chimiques nécessaires au nettoyage des supports en plastique.

Par ailleurs, il faut autant de compositions colorées que de couleurs d'articles revêtus proposés à la vente, ce qui impose une contrainte supplémentaire en termes de stockage.

Le but de l'invention est, par conséquent, de pallier les inconvénients qui viennent d'être mentionnés et de proposer un procédé de fabrication d'un article revêtu qui soit non seulement moins polluant mais également de mise en oeuvre industrielle plus aisée que celui de l'art antérieur. Plus particulièrement, le procédé selon l'invention doit limiter le recours à des équipements lourds de capture des vapeurs de peinture et doit pouvoir être mis en oeuvre avec un nombre d'étapes réduit par rapport celui du procédé de l'art antérieur et, en particulier, en l'absence d'étape(s) de retraitement d'effluents.

Le procédé selon l'invention doit en outre permettre de fabriquer des articles revêtus présentant une gamme de couleurs qui soit la plus étendue possible et qui ne se trouve pas limitée par la couleur des compositions présentes dans le stock.

Un autre but de l'invention est de proposer un article revêtu, notamment un article susceptible d'être obtenu par le procédé de fabrication qui vient d'être énoncé, dont le revêtement présente des fonctions de décoration, d'isolation électrique et de protection qui sont au moins aussi performantes, si ce n'est plus, que celles conférées par les revêtements des articles de l'art antérieur.

### EXPOSÉ DE L'INVENTION

Les buts précédemment énoncés ainsi que d'autres sont atteints, en premier lieu, par un procédé de fabrication d'un article revêtu du type précité, c'est-à-dire un article comprenant un support et un revêtement disposé sur au moins une face dudit support.

Selon l'invention, ce procédé de fabrication comprend les étapes successives suivantes :
(a) le dépôt, sur ladite face du support, d'un matériau métallique pour former une première couche,
(b) le dépôt, sur ladite première couche formée lors de l'étape (a), d'un matériau céramique comprenant du fluorophlogopite et du verre borosilicaté pour former une deuxième couche, ce dépôt étant réalisé par un procédé de dépôt physique en phase vapeur (PVD),
ledit revêtement comprenant au moins la première et la deuxième couches.

Le procédé de dépôt physique en phase vapeur (en anglais, Physical Vapor Deposition ou PVD), ou procédé PVD, est un procédé de dépôt réalisé à basse pression dans une enceinte sous vide partiel. Le procédé PVD permet de réaliser des dépôts de matériaux avec de très faibles épaisseurs, allant de quelques dizaines de nanomètres à quelques dizaines de micromètres.

Or, de manière surprenante et inattendue, les inventeurs ont observé que le dépôt, par un procédé PVD, du matériau céramique comprenant du fluorophlogopite et du verre borosilicaté, qui a un aspect initial blanc, permet d'obtenir une deuxième couche qui est à la fois transparente et qui confère à l'article revêtu obtenu une couleur différente en fonction de l'épaisseur de cette deuxième couche.

Ainsi, en faisant varier l'épaisseur de cette deuxième couche, on peut décliner une grande variété de couleurs différentes à partir d'une seule combinaison de support et de première couche. Le procédé selon l'invention permet donc d'offrir une gamme de couleurs très étendue, qui ne se trouve pas limitée par le nombre de couleurs des compositions de couches présentes en stock.

De plus, le procédé PVD permet une excellente maîtrise des épaisseurs, et donc des quantités, de matières déposées, ce qui n'est pas réellement le cas avec les procédés de dépôt, notamment par enduction ou pulvérisation, des couches de peinture. Ainsi, le procédé selon l'invention permet une remarquable reproductibilité des articles revêtus fabriqués que ce soit, pour l'obtention d'une gamme étendue de couleurs ou pour l'obtention d'une couleur particulière. On peut ainsi reproduire un article revêtu d'une même couleur, quel que soit le laps de temps écoulé entre les fabrications.

Parmi les différents procédés PVD disponibles, on peut notamment envisager la technique d'évaporation sous vide ainsi que la pulvérisation cathodique.

Selon un mode de réalisation de l'invention, on peut envisager le dépôt d'au moins une troisième couche, le revêtement comprenant alors ladite troisième couche en plus des première et deuxième couches.

Cette troisième couche peut être une couche intermédiaire disposée au-dessus du support, plus précisément entre le support et la première couche. Une telle couche intermédiaire peut être une couche d'accrochage permettant de renforcer l'adhérence entre le support et le revêtement.

Cette troisième couche peut également être une couche disposée au-dessus de la deuxième couche. De préférence, cette troisième couche est transparente pour permettre de visualiser la couleur de l'article revêtu conférée par la combinaison de la première couche et la deuxième couche.

Selon une version particulièrement avantageuse de l'invention, le revêtement est constitué par la première et la deuxième couches.

Ainsi, et contrairement au procédé de fabrication de l'art antérieur qui nécessite le dépôt de trois couches pour l'obtention du revêtement, le procédé selon l'invention permet de réaliser un revêtement qui ne comprend que deux couches.

En plus de limiter le nombre de matières premières nécessaires à la fabrication de l'article revêtu, le procédé de fabrication selon l'invention permet également de réduire le nombre d'étapes et d'équipements industriels associés. Le procédé selon l'invention présente donc un intérêt indéniable en termes de limitation des coûts de fabrication. En outre, cette limitation du nombre de matières premières permettant de former le revêtement favorise également le recyclage de l'article revêtu.

Selon une autre version particulièrement avantageuse de l'invention, le dépôt de l'étape (a) qui permet de former la première couche sur le support est également réalisé par un procédé de dépôt physique en phase vapeur (PVD).

Le dépôt de cette première couche par le procédé PVD permet également d'en contrôler l'épaisseur et d'optimiser encore la reproductibilité du procédé de fabrication selon l'invention.

Comme pour le dépôt réalisé lors de l'étape (b), le dépôt de la première couche par le procédé PVD peut notamment être envisagé par la mise en oeuvre de la technique d'évaporation sous vide ou celle de la pulvérisation cathodique.

Dans une version préférentielle de l'invention, les dépôts par procédé PVD de la première couche puis de la deuxième couche du revêtement sont réalisés *in situ,* dans une même enceinte, ce qui présente l'avantage d'éviter toute manipulation de l'article et, par conséquent, d'éliminer les risques de souillure de ce dernier, au cours de sa fabrication.

Dans un mode de réalisation particulier du procédé selon l'invention, la première couche présente une épaisseur inférieure ou égale à 500 nm.

Par ailleurs, le procédé PVD permet de s'exonérer d'étape(s) de séchage, éventuellement par traitement thermique, entre les dépôts successifs des différentes couches, contrairement à certaines variantes du procédé de l'art antérieur.

En outre, comme le procédé PVD n'engendre pas de pollution du type de celle qui est inhérente au procédé de l'art antérieur, le procédé de fabrication selon l'invention est réalisé dans des conditions industrielles qui sont tout à fait satisfaisantes du point de vue environnemental.

Dans un mode de réalisation du procédé selon l'invention, l'étape (a) de dépôt de la première couche est précédée d'une étape de nettoyage de la face du support destinée à recevoir le revêtement, cette étape de nettoyage étant de préférence réalisée autrement que par trempage dans un bain chimique, comme dans le cas du procédé de l'art antérieur.

Ce nettoyage peut notamment être effectué au moyen d'un solvant, tel qu'un alcool, ou encore par "etching", le "etching consistant en un procédé de nettoyage par polarisation du support qui est réalisé *in situ,* dans l'enceinte dans laquelle sont réalisés les dépôts, par le procédé PVD, de la deuxième couche et, le cas échéant, de la première couche.

Dans un autre mode de réalisation du procédé selon l'invention, l'étape (a) de dépôt de la première couche est précédée d'une étape d'activation de la face du support destinée à recevoir le revêtement. Cette étape d'activation permet d'améliorer l'adhérence de la première couche sur ladite face du support.

Cette étape d'activation peut être réalisée directement sur le support, en l'absence d'étape de nettoyage telle que mentionnée précédemment. Dans le cas où une étape de nettoyage est mise en oeuvre, l'étape d'activation est avantageusement réalisée après celle de nettoyage.

Cette étape d'activation peut en particulier être réalisée au moyen d'une torche à plasma atmosphérique.

La première couche du revêtement est réalisée par le dépôt, sur au moins l'une des faces du support, d'un matériau métallique.

Ce matériau métallique de la première couche peut être formé par n'importe quel métal ou n'importe quel alliage métallique, l'alliage métallique étant formé de deux ou plusieurs métaux, éventuellement en mélange avec un ou plusieurs non-métaux ou métalloïdes. La définition des métaux, non-métaux et métalloïdes qui viennent d'être cités est celle classiquement retenue par le tableau périodique des éléments de Mendeleïev.

Le choix du matériau métallique peut notamment être déterminé par la gamme de couleurs et l'aspect métallique (par exemple, mat ou brillant) que l'on souhaite obtenir pour le revêtement.

Avantageusement, ce matériau de la première couche est formé par un métal choisi parmi les métaux de transition et les métaux pauvres, par un alliage métallique comprenant deux ou plusieurs desdits métaux, ou par un acier inoxydable.

De préférence, le métal de transition est choisi parmi le titane, le chrome, le fer, le cuivre et le zinc tandis que le métal pauvre est choisi parmi l'aluminium et l'étain.

On peut ainsi plus particulièrement envisager l'utilisation d'un alliage de titane et d'aluminium TiAl, de cuivre et d'aluminium CuAl ou de zinc et d'aluminium ZnAl, pour le matériau métallique de la première couche.

La deuxième couche du revêtement est réalisée par le dépôt, par un procédé PVD, d'un matériau céramique.

Ce matériau céramique comprend du fluorophlogopite et du verre, ce verre étant de préférence un verre borosilicaté. Ce matériau céramique comprend environ 55% de fluorophlogopite et 45% de verre borosilicaté.

Ce matériau, qui a l'apparence de la porcelaine, se présente notamment sous la forme de plaques ou de barres de couleur blanche. Il est notamment disponible auprès de la société Corning, sous la dénomination commerciale Macor^{®}. D'après les informations mises à disposition par la société Corning elle-même, ce matériau céramique utilisé pour la deuxième couche du revêtement a la composition suivante, les pourcentages étant donnés en masse :
- 46% de SiO₂
- 17% de MgO
- 16% de Al₂O₃
- 10% de K₂O
- 7% de B₂O₃, et
- 4% de F.

On observe que ce matériau céramique dans lequel est réalisée la deuxième couche est un matériau qui comprend très majoritairement du dioxyde de silicium SiO₂ Or, s'il est bien connu que le dioxyde de silicium est difficile à mettre en oeuvre dans un procédé PVD, car une cible de SiO₂ est trop fragile mécaniquement et se casse, il n'en est pas de même avec le matériau céramique ci-dessus comprenant du fluorophlogopite et du verre borosilicaté qui supporte très bien ce procédé PVD.

Ce matériau céramique, qui est connu pour être un matériau diélectrique, conserve cette propriété lorsqu'il est déposé, par le procédé PVD, sous forme de couche mince pour la réalisation de la deuxième couche.

Par ailleurs, les inventeurs ont observé que, bien que blanc à l'état solide ou massif, ce matériau céramique, lorsqu'il est déposé sous forme de couche mince par le procédé PVD, donne une deuxième couche transparente qui, en fonction de son épaisseur, modifie la couleur finale du revêtement et donc, de l'article qui en est revêtu.

Dans un mode de réalisation particulier du procédé selon l'invention, la deuxième couche présente une épaisseur inférieure ou égale à 1 µm.

On observe que, malgré cette faible épaisseur de 1 µm ou moins, la deuxième couche du revêtement réalisée par le dépôt, par le procédé PVD, du matériau céramique comprenant du fluorophlogopite et du verre borosilicaté confère, au revêtement de l'article fabriqué par le procédé selon l'invention, une excellente résistance à la rayure qui, mesurée selon le test de dureté ISO 15184, s'élève jusqu'à 5N, voire 7N. Cette résistance à la rayure n'est pas liée à la résistance mécanique intrinsèque du matériau céramique de la deuxième couche mais à l'aptitude qu'a ce matériau de faire glisser, au niveau de sa surface en contact avec l'environnement extérieur, tout objet mécaniquement agressif, empêchant ainsi l'apparition de la rayure. A titre de comparaison, de telles valeurs de résistance à la rayure ne sont atteintes qu'avec des couches de peinture présentant une épaisseur d'environ 10 µm dans le procédé de fabrication de l'art antérieur.

Par conséquent, le procédé de fabrication selon l'invention permet d'obtenir un article doté d'un revêtement qui présente une résistance à la rayure très performante avec une épaisseur de deuxième couche particulièrement faible.

L'épaisseur de la deuxième couche du revêtement est avantageusement comprise entre 10 nm et 1000 nm, préférentiellement entre 50 nm et 500 nm et, plus préférentiellement encore, entre 100 nm et 300 nm.

Dans un mode de réalisation particulièrement avantageux du procédé selon l'invention, le revêtement, qui comprend au moins les première et deuxième couches, présente une épaisseur totale inférieure ou égale à 10 µm, c'est-à-dire une épaisseur qui se trouve être au moins 5 fois plus faible que celle du revêtement obtenu avec la mise en oeuvre du procédé de fabrication de l'art antérieur. Il est donc indéniable que le procédé de fabrication de l'article revêtu selon l'invention permet de réaliser un gain de matière particulièrement appréciable tant sur le plan industriel qu'économique.

Le support de l'article, quant-à-lui, peut être en un matériau quelconque, qui peut notamment être adapté en fonction du prix et/ou de la destination final(e) de l'article.

Ce support peut notamment être en un matériau plastique, métallique ou en un alliage métallique, ou encore en verre.

Dans le cas particulier des plaques et/ou boutons de commande d'interrupteurs et prises électriques, un support en plastique est préférable, notamment pour des raisons économiques.

Le plastique avantageusement utilisé pour le support peut être choisi parmi les polymères thermoplastiques, notamment parmi le polycarbonate (PC), l'acrylonitrile-butadiène-styrène (ABS), le polyméthacrylate de méthyle (PMMA) et leur mélange tel que le mélange PC/ABS.

La présente invention se rapporte, en deuxième lieu, à un article, en particulier un article revêtu, qui comprend un support et un revêtement disposé sur au moins une face dudit support.

Selon l'invention, cet article est susceptible d'être obtenu par le procédé de fabrication tel que défini ci-dessus, les caractéristiques avantageuses de ce procédé pouvant être prises seules ou en combinaison.

Ainsi, le revêtement de cet article comprend :
- une première couche disposée sur ladite face du support et réalisée en un matériau métallique, et
- une deuxième couche disposée sur ladite première couche et réalisée en un matériau céramique déposé par un procédé de dépôt physique en phase vapeur (PVD), ce matériau céramique comprenant du fluorophlogopite et du verre borosilicaté.

Cet article revêtu peut avantageusement être une plaque ou un bouton de commande d'interrupteur électrique ou encore une plaque de prise électrique.

Dans une variante de réalisation de l'invention, le revêtement peut comprendre en outre au moins une troisième couche, en plus des première et deuxième couches.

Cette troisième couche peut être une couche intermédiaire disposée en dessous de la première couche ou être disposée au-dessus de la deuxième couche.

Dans une variante de réalisation particulièrement avantageuse de l'invention, le revêtement n'est constitué que par la première et la deuxième couches.

Selon un premier mode de réalisation de l'article selon l'invention, la deuxième couche du revêtement constitue la couche destinée à être disposée du côté de l'environnement extérieur. Dans ce premier mode, la deuxième couche, qui est la couche apparente et en contact avec cet environnement extérieur, confère à l'article une fonction de protection améliorée par rapport à celle des articles de l'art antérieur. En effet, cet article présente une résistance à la rayure améliorée.

Selon un second mode de réalisation de l'article selon l'invention, le support constitue la couche destinée à être disposée du côté de l'environnement extérieur. Dans ce second mode, le support est préférentiellement transparent afin de permettre au consommateur de visualiser la couleur conférée par le revêtement. La perception de cette couleur conférée par le revêtement est d'autant plus perceptible que l'épaisseur de la première couche en matériau métallique dudit revêtement est faible, notamment inférieure ou égale à 500 nm et, par exemple, comprise entre 50 nm et 300 nm.

Dans une variante de l'invention, qui peut être mise en oeuvre avec le premier ou le second mode de réalisation qui vient d'être décrit, l'article comprend en outre une couche de protection disposée sur la couche destinée à être disposée du côté de l'environnement extérieur. Cette couche de protection peut permettre de conférer une texturation de surface à l'article mais également améliorer la résistance mécanique et/ou chimique, en particulier dans le second mode de réalisation de l'article selon l'invention.

La présente invention se rapporte, en troisième lieu, à un dispositif électrique.

Selon l'invention, ce dispositif électrique comprend un article tel que défini ci-dessus, les caractéristiques avantageuses de cet article pouvant être prises seules ou en combinaison.

Un tel dispositif peut notamment être un interrupteur ou une prise électrique. En particulier, l'article peut être constitué par la plaque et/ou par le bouton de commande de l'interrupteur ou par la plaque de la prise.

D'autres caractéristiques et avantages de l'invention apparaîtront mieux à la lecture du complément de description qui suit, qui se rapporte à un exemple de réalisation d'un article susceptible d'être fabriqué conformément au procédé selon l'invention ainsi qu'à une évaluation et une quantification de la variation de couleurs obtenue en fonction de l'épaisseur de la deuxième couche du revêtement réalisé sur un support.

Cette description détaillée, qui se réfère notamment aux figures 3 à 5 telles qu'annexées, est donnée à titre d'illustration de l'objet de l'invention et ne constitue en aucun cas une limitation de cet objet.

### BRÈVE DESCRIPTION DES DESSINS

La figure 1 est un cliché photographique d'un bouton de commande d'interrupteur électrique tel que fabriqué par le procédé de l'art antérieur.
La figure 2 est un cliché microscopique en coupe transversale d'un article revêtu conformément au procédé de l'art antérieur.
La figure 3 est une représentation schématique d'une coupe transversale d'un article revêtu conforme à l'invention.
La figure 4 représente les courbes spectrales obtenues pour quatre articles dont trois conformes à l'invention (articles B à D), le dernier constituant l'article de référence (article A).
La figure 5 illustre les coordonnées colorimétriques déterminées selon le système CIE Lab 1976 de ces mêmes trois articles conformes à l'invention (articles B à D), par rapport à l'article de référence (article A).

Il est précisé que les figures 1 et 2 ont chacune déjà fait l'objet d'un commentaire dans le précédent chapitre.

### EXPOSÉ DÉTAILLÉ DE MODES DE RÉALISATION PARTICULIERS

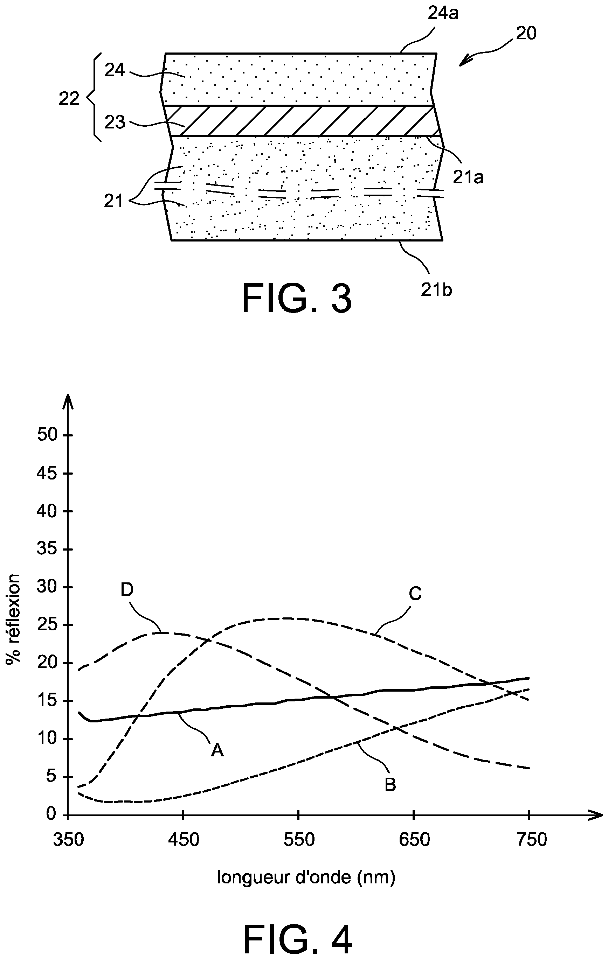

Pour caractériser la variation de couleur d'un article revêtu conforme à l'invention, on a réalisé quatre articles dont trois conformes à l'invention et pour lesquels la structure commune est décrite ci-après en référence à la figure 3.

### Structure d'un article conforme à l'invention

On a représenté, sur la figure 3, une vue partielle schématique d'une coupe transversale d'un article 20 conforme à l'invention.

Cet article 20, qui est fabriqué selon le procédé de l'invention, comprend un support 21 et un revêtement 22.

Ce support 21 comprend deux faces 21a et 21b opposées l'une à l'autre.

Sur la face 21a de ce support 21, est disposée une première couche 23.

Sur cette première couche 23 est disposée une deuxième couche 24.

Dans une première variante de l'invention, la deuxième couche 24 constitue la couche destinée à être disposée du côté de l'environnement extérieur. Dans cette hypothèse, la face 24a de la deuxième couche 24 constitue la face apparente de l'article 20.

Dans une autre variante de l'invention, le support 21 constitue la couche destinée à être disposée du côté de l'environnement extérieur. Dans cette hypothèse, la face 21b du support 21 constitue la face apparente de l'article 20.

Dans la représentation de la figure 3, le revêtement 22, étant constitué par la première couche 23 et la deuxième couche 24, ne comprend que deux couches.

Toutefois, rien n'interdit d'envisager la présence d'au moins une troisième couche pour la réalisation de l'article 20.

On pourrait notamment envisager la présence d'une troisième couche, par exemple une couche dite de protection, non représentée sur la figure 3.

Cette couche de protection peut aussi bien être disposée sur la deuxième couche 24, au niveau de sa face 24a, que sur la face 21b du support 21. Une telle couche de protection peut être conformée de manière à être texturée.

De manière plus particulièrement avantageuse, cette troisième couche est disposée sur la couche, parmi la deuxième couche 24 et le support 21, qui est destinée à être disposée du côté de l'environnement extérieur.

### Evaluation de la variation de couleurs

Pour la conduite du test permettant d'évaluer la variation de couleurs d'un article conforme à l'invention, on a fabriqué quatre articles revêtus référencés A à D comprenant un même support mais un revêtement de structure distincte.

Le support, qui est commun aux quatre articles A à D, est constitué par une plaque de forme carrée réalisée en acrylonitrile-butadiène-styrène (ABS) et présentant une épaisseur de 3 mm pour une largeur de 50 mm.

Après une étape d'activation de la surface à revêtir des quatre plaques au moyen d'une torche à plasma atmosphérique, on a procédé au dépôt, par un procédé de dépôt physique en phase vapeur (PVD), d'une première couche réalisée en un alliage métallique comprenant du titane et de l'aluminium.

Pour ce faire, chacune des quatre plaques a été successivement disposée, dans une enceinte de dépôt PVD, à une distance de 10 cm de la source de l'alliage métallique mentionné ci-dessus, la vitesse de rotation de ladite plaque étant fixée à 2 tours par min. L'enceinte a été placée sous une pression de 10⁻³ mbar sous 40 cm³ d'argon. On a alors procédé au dépôt de la première couche par application d'une puissance en courant continu (DC) de 150 W pendant 60 min.

Une même première couche d'alliage métallique TiAl tant en composition qu'en épaisseur, en l'espèce de l'ordre de 1 à 2 µm, est ainsi réalisée sur chacune des quatre plaques des articles A à D.

On a ensuite procédé au dépôt, toujours au moyen d'un procédé de dépôt physique en phase vapeur (PVD), d'une deuxième couche réalisée en un matériau céramique comprenant du fluorophlogopite et du verre borosilicaté.

Pour ce faire, trois des quatre plaques revêtues de la première couche de TiAl ont été successivement introduites dans une enceinte de dépôt PVD dans laquelle est disposée une source du matériau céramique mentionné ci-dessus.

Ce matériau céramique, qui se présente sous la forme d'un disque, est disponible auprès de la société Corning, sous la dénomination commerciale Macor^{®}.

Les conditions opératoires appliquées ont été les suivantes : chacune des trois plaques revêtues de la première couche de TiAl a été disposée, dans l'enceinte de dépôt PVD, à une distance de 7 cm de la source de Macor^{®}, la vitesse de rotation de ladite plaque étant fixée à 2 tours par min. L'enceinte a été placée sous une pression de 10⁻³ mbar sous 40 cm³ d'argon. Une puissance de 80 MW RF a été appliquée, le temps d'application ayant été modulé entre 30 et 60 min, conformément aux indications portées dans le tableau 1 ci-dessous. L'épaisseur correspondante de la deuxième couche de Macor^{®} ainsi obtenue est également reportée dans le tableau 1 ci-dessous.

La plaque seulement revêtue de la première couche d'alliage métallique correspond à l'article A, qui est considéré comme l'article de référence. Les trois autres plaques revêtues des première et deuxième couches sont respectivement désignées B, C et D, en fonction du temps d'application de ladite deuxième couche.

Une observation à l'oeil nu des couleurs présentés par les articles A à D montre une variation de la couleur qui passe du gris métallique pour l'article A, au marron clair pour l'article B, au marron foncé pour l'article C et au noir avec un effet bleuté pour l'article D, comme reporté dans le tableau 1 ci-dessous.

**Tableau 1**

| Article | A | B | C | D |
|---|---|---|---|---|
| Temps d'application (min) | - | 30 | 45 | 60 |
| Epaisseur obtenue (nm) | - | 100 | 150 | 220 |
| Couleurs de l'article | gris | marron clair | marron foncé | noir bleuté |

Pour confirmer cette variation de couleurs des articles A à D tel qu'observable à l'oeil nu, on a réalisé la courbe spectrale correspondant à chacun des articles A à D. La courbe spectrale reflète la capacité de l'article à absorber et diffuser certaines longueurs d'onde de la lumière incidente, en l'espèce la lumière naturelle en plein jour en zone tempérée, également dénommée "Illuminant D65".

Les courbes spectrales obtenues, qui correspondent au rapport énergétique de l'énergie réfléchie par rapport à l'énergie incidente, ou réflexion (en %), pour chaque longueur d'onde de lumière incidente, sont représentées à la figure 4.

La courbe de réflexion obtenue avec l'article A dépourvu de deuxième couche en Macor^{®} présente une réflexion comprise entre 15% et 17% sur tout le spectre de longueur d'onde, ce qui est caractéristique d'un gris sombre.

Avec l'augmentation de l'épaisseur de la deuxième couche en Macor^{®}, on observe un décalage du pic de réflexion vers les plus faibles longueurs d'ondes. Ainsi, avec une deuxième couche d'une épaisseur de 100 nm, l'article B présente un pic de réflexion situé dans les longueurs d'onde correspondant au rouge, tandis que les pics de réflexion des articles C et D, de 150 nm et 220 nm d'épaisseur, s'établissent au niveau des longueurs d'onde correspondant au bleu-vert pour l'article C et au violet pour l'article D.

La variation de couleurs des articles A à D telle que perceptible à l'oeil nu est donc bien confirmée par ces courbes spectrales de la figure 4.

Pour quantifier cette variation de couleurs, on a procédé au calcul des écarts colorimétriques selon le système CIE Lab 1976 entre chacun des trois autres articles B, C et D conformes à l'invention et le standard constitué par l'article A.

Les coordonnées rectangulaires L*a*b* et cylindriques L*C*h° colorimétriques du système CIE Lab telles que mesurées pour l'Illuminant D65 et l'observateur situé à 10° sont reportées dans le tableau 2 ci-dessous.

A partir de ces valeurs, on peut déterminer les écarts colorimétriques entre l'article A de référence et chacun des articles B, C et D qui sont donnés par les formules suivantes :
dL* : écart de clarté, avec dL* = L*_{B}- L*_{A}
da* : écart sur l'axe rouge/vert, avec da* = a*_{B}-a*_{A}
db* : écart sur l'axe jaune/bleu, avec db* = b*_{B} - b^{*}_{A}
dC^{*} : écart de chroma ou saturation, avec dC* = C*_{B} - C*_{A}
dH* : écart de tonalité chromatique, avec dH* = H*_{B} - H*_{A},
les indices A et B correspondant aux valeurs respectivement relevées pour l'article A et pour l'article B. Les calculs sont les mêmes avec les articles C et D.

Les valeurs de coordonnées rectangulaires et cylindriques mesurées ainsi que les valeurs d'écarts colorimétriques calculées sont reportées dans le tableau 2 ci-dessous.

**Tableau 2**

| Article | A | B | C | D |
|---|---|---|---|---|
| L* | 45,80 | 31,96 | 57,06 | 49,12 |
| a* | 0,97 | 7,14 | -5,85 | -6,83 |
| b* | 3,55 | 22,99 | 8,67 | -11,11 |
| C* | 3,69 | 24,07 | 10,46 | 13,05 |
| h° | 74,67 | 72,74 | 124,03 | 238,42 |
| dL* | | -14 | 11 | 3 |
| da* | | 6 | -7 | -8 |
| db* | | 19 | 5 | -15 |
| dC* | | 20 | 7 | 9 |
| dH* | | -0,4 | 5 | 14 |

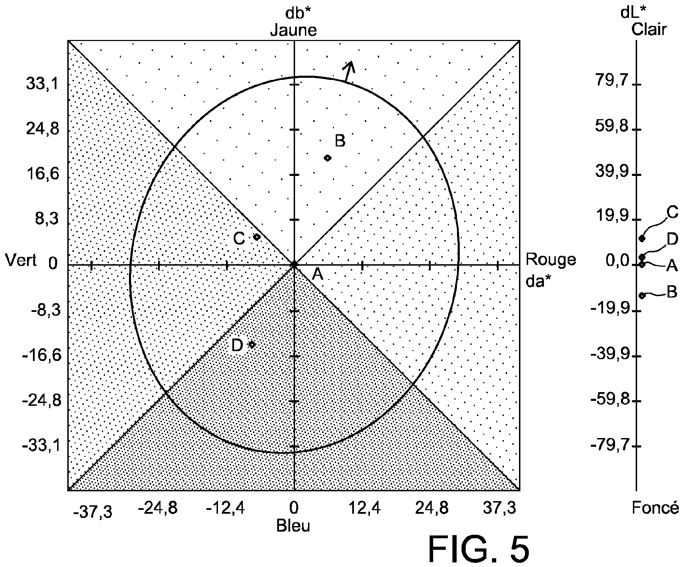

Les valeurs de dL* ont été reportées sur la partie droite de la figure 5. On observe que la couleur de l'article B, dont la valeur de dL* est négative, est plus foncée que celle des autres articles A, C et D. La couleur de l'article C est, quant-à-elle, la plus claire de toutes.

Sur le graphe de la partie gauche de la figure 5 sont reportées les valeurs de da* et db* pour chacun des articles A à D. La disposition des points ainsi repérés montre bien que les articles B, C et D présentent une couleur distincte, non seulement de celle de l'article A, mais également entre elles. L'article B présente une couleur ayant une dominante jaune/rouge tandis que les articles C et D présentent une couleur ayant une dominante respectivement verte/jaune pour l'article C et bleue/verte pour l'article D.

La variation de couleurs des articles A à D telle que perceptible à l'oeil nu est donc clairement démontrée par les données colorimétriques de la figure 5.

## Revendications

1. Procédé de fabrication d'un article (20) comprenant un support (21) et un revêtement (22) disposé sur au moins une face (21a) dudit support (21), **caractérisé en ce qu'**il comprend les étapes successives suivantes :
(a) le dépôt, sur ladite face (21a) du support (21), d'un matériau métallique pour former une première couche (23),
(b) le dépôt, sur ladite première couche (23) formée lors de l'étape (a), d'un matériau céramique comprenant du fluorophlogopite et du verre borosilicaté pour former une deuxième couche (24), ce dépôt étant réalisé par un procédé de dépôt physique en phase vapeur (PVD),
ledit revêtement (22) comprenant au moins la première et la deuxième couches (23, 24).

2. Procédé selon la revendication 1, dans lequel le revêtement (22) est constitué par la première et la deuxième couches (23, 24).

3. Procédé selon la revendication 1 ou 2, dans lequel le dépôt de l'étape (a) est réalisé par un procédé de dépôt physique en phase vapeur (PVD).

4. Procédé selon l'une quelconque des revendications 1 à 3, dans lequel l'étape (a) est précédée d'une étape d'activation de la face (21a) du support (21) destinée à recevoir le revêtement (22), cette étape d'activation pouvant être réalisée au moyen d'une torche à plasma atmosphérique.

5. Procédé selon l'une quelconque des revendications 1 à 4, dans lequel la composition du matériau céramique de la deuxième couche (24) est la suivante, les pourcentages étant donnés en masse :
- 46%de SiO₂
- 17% de MgO
- 16% de Al₂O₃
- 10% de K₂O
- 7% de B₂O₃, et
- 4% de F.

6. Procédé selon l'une quelconque de revendications 1 à 5, dans lequel le matériau de la première couche (23) est formé par un métal choisi parmi les métaux de transition, notamment parmi le titane, le chrome, le fer, le cuivre et le zinc, et les métaux pauvres, notamment parmi l'aluminium et l'étain, par un alliage métallique comprenant deux ou plusieurs desdits métaux, ou par un acier inoxydable.

7. Procédé selon la revendication 6, dans lequel le matériau de la première couche (23) est en alliage de titane et d'aluminium TiAl, de cuivre et d'aluminium CuAl ou de zinc et d'aluminium ZnAl.

8. Procédé selon l'une quelconque de revendications 3 à 7, dans lequel la première couche (23) présente une épaisseur inférieure ou égale à 500 nm.

9. Procédé selon l'une quelconque de revendications 1 à 8, dans lequel la deuxième couche (24) présente une épaisseur inférieure ou égale à 1 µm, avantageusement comprise entre 10 nm et 1000 nm, préférentiellement entre 50 nm et 500 nm et, plus préférentiellement encore, entre 100 nm et 300 nm.

10. Procédé selon l'une quelconque de revendications 1 à 9, dans lequel le revêtement (22) présente une épaisseur totale inférieure ou égale à 10 µm.

11. Article susceptible d'être obtenu par le procédé selon l'une quelconque des revendications 1 à 10, notamment plaque ou bouton de commande.

12. Article (20) selon la revendication 11, dans lequel la deuxième couche (24) constitue la couche destinée à être disposée du côté de l'environnement extérieur, l'article (20) présentant alors une résistance à la rayure améliorée.

13. Article (20) selon la revendication 11, dans lequel le support (21) constitue la couche destinée à être disposée du côté de l'environnement extérieur.

14. Article (20) selon la revendication 12 ou 13, dans lequel l'article (20) comprend en outre une couche de protection disposée sur la couche destinée à être disposée du côté de l'environnement extérieur.

15. Dispositif électrique, notamment interrupteur ou prise, comprenant un article (20) selon l'une quelconque des revendications 11 à 14.

## Patentansprüche

1. Verfahren zum Herstellen eines Gegenstands (20) mit einem Träger (21) und einer Beschichtung (22), die an zumindest einer Seite (21a) des Trägers (21) angeordnet ist, **dadurch gekennzeichnet, dass** es die nachstehenden, aufeinanderfolgenden Schritte umfasst:
(a) Aufbringen eines metallischen Materials auf die genannte Seite (21a) des Trägers (21), um eine erste Schicht (23) zu bilden,
(b) Aufbringen eines keramischen Materials mit Fluorphlogopit und Borosilikatglas auf die genannte erste Schicht (23), die in Schritt (a) gebildet wurde, um eine zweite Schicht (24) zu bilden, wobei dieses Aufbringen mit einem Verfahren mit physikalischer Dampfphasenabscheidung (PVD) erfolgt, wobei die Beschichtung (22) zumindest die erste und die zweite Schicht (23, 24) umfasst.

2. Verfahren nach Anspruch 1, wobei die Beschichtung (22) aus der ersten und der zweiten Schicht (23, 24) besteht.

3. Verfahren nach Anspruch 1 oder 2, wobei das Aufbringen in Schritt (a) mit einem Verfahren mit physikalischer Dampfphasenabscheidung (PVD) erfolgt.

4. Verfahren nach einem der Ansprüche 1 bis 3, wobei dem Schritt (a) ein Schritt des Aktivierens der Seite (21a) des Trägers (21), welche die Beschichtung (22) erhalten soll, vorausgeht, wobei dieser Aktivierungsschritt mittels eines atmosphärischen Plasmabrenners erfolgen kann.

5. Verfahren nach einem der Ansprüche 1 bis 4, wobei die Zusammensetzung des keramischen Materials der zweiten Schicht (24) folgende ist, wobei die Prozentwerte in Masse angegeben sind:
- 46 % SiO₂
- 17 % MgO
- 16 % Al₂O₃
- 10 % K₂O
- 7 % B₂O₃ und
- 4 % F.

6. Verfahren nach einem der Ansprüche 1 bis 5, wobei das Material der ersten Schicht (23) aus einem Metall gebildet ist, ausgewählt aus Übergangsmetallen, insbesondere aus Titan, Chrom, Eisen, Kupfer und Zink, und "armen" Metallen, insbesondere aus Aluminium und Zinn, aus einer Metalllegierung mit zwei oder mehreren der genannten Metalle oder aus einem Edelstahl.

7. Verfahren nach Anspruch 6, wobei das Material der ersten Schicht (23) eine Legierung aus Titan und Aluminium TiAl, Kupfer und Aluminium CuAl oder Zink und Aluminium ZnAl ist.

8. Verfahren nach einem der Ansprüche 3 bis 7, wobei die erste Schicht (23) eine Materialstärke kleiner oder gleich 500 nm aufweist.

9. Verfahren nach einem der Ansprüche 1 bis 8, wobei die zweite Schicht (24) eine Materialstärke kleiner oder gleich 1 µm, vorteilhaft zwischen 10 nm und 1000 nm, vorzugsweise zwischen 50 nm und 500 nm und besonders bevorzugt zwischen 100 nm und 300 nm, aufweist.

10. Verfahren nach einem der Ansprüche 1 bis 9, wobei die Beschichtung (22) eine Gesamtstärke kleiner oder gleich 10 µm aufweist.

11. Gegenstand, der mit dem Verfahren nach einem der Ansprüche 1 bis 10 erhalten werden kann, insbesondere Steuerplatte bzw. -taste.

12. Gegenstand (20) nach Anspruch 11, wobei die zweite Schicht (24) die Schicht bildet, die auf der Seite der Außenumgebung angeordnet werden soll, wobei der Gegenstand (20) dann eine höhere Kratzfestigkeit aufweist.

13. Gegenstand (20) nach Anspruch 11, wobei der Träger (21) die Schicht bildet, die auf der Seite der Außenumgebung angeordnet werden soll.

14. Gegenstand (20) nach Anspruch 12 oder 13, wobei der Träger (20) ferner eine Schutzschicht aufweist, die auf der Schicht angeordnet ist, die auf der Seite der Außenumgebung angeordnet werden soll.

15. Elektrische Vorrichtung, insbesondere Schalter oder Steckdose, umfassend einen Gegenstand (20) nach einem der Ansprüche 11 bis 14.

## Claims

1. Method for producing an item (20) comprising a substrate (21) and a coating (22) arranged on at least one face (21a) of said substrate (21), **characterised in that** it comprises the following successive steps:
(a) depositing, on said face (21a) of the substrate (21), a metallic material to form a first layer (23),
(b) depositing, on said first layer (23) formed during step (a), a ceramic material comprising fluorphlogopite and borosilicate glass to form a second layer (24), this deposition being carried out using a physical vapour deposition (PVD) process,
said coating (22) comprising at least the first and the second layers (23, 24).

2. Method according to claim 1, wherein the coating (22) consists of the first and the second layers (23, 24).

3. Method according to claim 1 or 2, wherein the deposition in step (a) is carried out using a physical vapour deposition (PVD) process.

4. Method according to any one of claims 1 to 3, wherein step (a) is preceded by a step for activating the face (21a) of the substrate (21) intended to receive the coating (22), this activation step being suitable for being carried out by means of an atmospheric plasma torch.

5. Method according to any one of claims 1 to 4, wherein the composition of the ceramic material of the second layer (24) is as follows, the percentages being given by mass:
- 46% of SiO₂
- 17% of MgO
- 16% of Al₂O₃
- 10% of K₂O
- 7% of B₂O₃, and
- 4% of F.

6. Method according to any one of claims 1 to 5, wherein the material of the first layer (23) is formed by a metal chosen from the transition metals, particularly from titanium, chromium, iron, copper and zinc, and the poor metals, particularly from aluminium and tin, by a metallic alloy comprising two or a plurality of said metals, or by stainless steel.

7. Method according to claim 6, wherein the material of the first layer (23) is made of alloy of titanium and aluminium TiAl, of copper and aluminium CuAl or of zinc and aluminium ZnAl.

8. Method according to any one of claims 3 to 7, wherein the first layer (23) has a thickness less than or equal to 500 nm.

9. Method according to any one of claims 1 to 8, wherein the second layer (24) has a thickness less than or equal to 1 µm, advantageously between 10 nm and 1000 nm, preferentially between 50 nm and 500 nm and, even more preferentially, between 100 nm and 300 nm.

10. Method according to any one of claims 1 to 9, wherein the coating (22) has a total thickness less than or equal to 10 µm.

11. Item suitable for being obtained using the method according to any one of claims 1 to 10, particularly plate or control button.

12. Item (20) according to claim 11, wherein the second layer (24) forms the layer intended to be arranged on the side of the external environment, the item (20) then exhibiting an enhanced scratch resistance.

13. Item (20) according to claim 11, wherein the substrate (21) forms the layer intended to be arranged on the side of the external environment.

14. Item (20) according to claim 12 or 13, wherein the item (20) further comprises a protective layer arranged on the layer intended to be arranged on the side of the external environment.

15. Electric device, particularly switch or socket, comprising an item (20) according to any one of claims 11 to 14.
